# EUROPEAN PATENT SPECIFICATION

(11) **EP 3 451 483 B1**
(45) Date of publication and mention of the grant of the patent: **05.08.2026**
(21) Application number: 18201262.5
(22) Date of filing: 11.06.2014
(51) Int. Cl.: H02J 3/38, F24F 5/00

(54) **PHOTOVOLTAIC AIR CONDITIONING SYSTEM**
PHOTOVOLTAISCHE KLIMAANLAGE
SYSTÈME PHOTOVOLTAÏQUE DE CLIMATISATION

(30) Priority: 25.09.2013 CN 201310442150
(43) Date of publication of application: 06.03.2019
(62) Divisional of application: 14849007.1
(73) Proprietor: Gree Electric Appliances, Inc. of Zhuhai, Zhuhai, Guangdong 519070 (CN)
(72) Inventor: Zhao, Zhigang, Zhuhai, Guangdong 519070 (CN); Chen, Ying, Zhuhai, Guangdong 519070 (CN); Liu, Huaican, Zhuhai, Guangdong 519070 (CN)
(74) Representative: Mathys & Squire

(56) References cited:
- CN-A- 102 705 944
- JP-A- H04 184 024
- US-A1- 2010 302 731
- US-B1- 8 373 303

## Description

### Technical field of the invention

The invention relates to the technical field of power electronics and air conditioning cooling, and in particular to a photovoltaic air conditioning system.

### Background of the invention

Solar energy, as clean energy, attracts more and more attention of people, and along with development of an electrical energy and an air conditioning technology, technologies of employing photovoltaic energy as energy for air conditioners emerge, and related technologies have been disclosed in many patents and dissertations. For example, Chinese invention patent application CN102705944A discloses a solar variable frequency air conditioning system, which includes an inverter module and an air conditioning frequency converter of a rectifier and inverter grid connection module, implements supplying of power to an air conditioner through a photovoltaic cell and also implements grid-connected power generation.

However, a photovoltaic air conditioning system in a conventional art has the problem of poor applicability, and there are more limits to auxiliary facilities. This is because a grid connection inverter module required by grid connection is a part of a frequency converter of an air conditioning unit in the conventional art and then the air conditioning unit is required to be powered on during grid-connected power generation, which may cause energy waste and influence on service life of the air conditioning unit. Moreover, only a photovoltaic cell component equivalent to power of the air conditioning unit may be configured under the limit of capacity of the air conditioning frequency converter, so that only a new photovoltaic power generation system may be established to be matched with the air conditioning system, and the air conditioning system may not be connected to an existing photovoltaic power plant, otherwise it is impossible to connect all electric energy generated by the photovoltaic power plant to a grid under the limit of capacity of the air conditioning frequency converter, which may cause great waste of the electric energy.

In addition, the conventional art also has the problem that an electronic power device such as an inverter and a current converter in a photovoltaic power generation system during shutdown of an air conditioning unit.

### Summary of the invention

In order to overcome shortcomings of the conventional art, the embodiment of the invention provides a photovoltaic air conditioning system, to solve the problem of poor applicability of a photovoltaic air conditioning system in the conventional art.

The embodiment of the invention provides the following technical solutions.

A photovoltaic air conditioning system is provided, which includes a photovoltaic cell array, an air conditioning unit, a current conversion unit, a first direct current bus-bar and a second direct current bus-bar, wherein the air conditioning unit further includes a first inverter module configured to supply power to the air conditioning unit and serving as a standard accessory of the air conditioning unit, and capacity of the first inverter module is configured according to power of the air conditioning unit; the current conversion unit is an independent structure, first end of the current conversion unit is connected with a public grid, second end of the current conversion unit is electrically connected with the first inverter module through the first direct current bus-bar, and capacity of the current conversion unit is configured according to a requirement of the photovoltaic cell array or the public grid; and the photovoltaic cell array is electrically connected with the first direct current bus-bar through the second direct current bus-bar.

Preferably, when output power of the photovoltaic cell array is higher than or equal to input power required by running of the air conditioning unit, the air conditioning unit is powered by the photovoltaic cell array only; and
when the output power of the photovoltaic cell array is lower than the input power required by running of the air conditioning unit, the air conditioning unit is jointly powered by the public grid and the photovoltaic cell array.

Preferably, when the output power of the photovoltaic cell array is higher than the input power required by running of the air conditioning unit, or when the air conditioning unit does not work, the current conversion unit is configured to convert direct current output by the photovoltaic cell array into alternating current for transmission to the public grid.

The current conversion unit includes a rectifier module and a second inverter module. The rectifier module is configured to convert alternating current of the public grid into direct current for supply to the air conditioning unit, and the second inverter module is configured to convert direct current generated by the photovoltaic cell array into alternating current for connection to the public grid.

Preferably, the current conversion unit is a four-quadrant current converter.

Preferably, the photovoltaic air conditioning system further includes a photovoltaic collector unit and power distribution unit which are arranged between the photovoltaic cell array and the second direct current bus-bar, and the photovoltaic cell array, the photovoltaic collector unit, the power allocation unit and the second direct current bus-bar are sequentially connected.

Preferably, the air conditioning unit is a centrifugal water-cooled air conditioning unit or a screw type water-cooled air conditioning unit.

The photovoltaic air conditioning system further includes a current conversion unit cooling device.

The air conditioning unit further includes an evaporator and a first condenser, the current conversion unit cooling device includes a coolant pump, throttling element and heat exchanger which are sequentially connected in series, a first end of the coolant pump is communicated with the first condenser, a second end of the coolant pump is communicated with the throttling element, a first end of the heat exchanger is communicated with the throttling element, a second end of the heat exchanger is communicated with the evaporator, and the current conversion unit is cooled by heat exchange of the heat exchanger and the current conversion unit.

Preferably, the current conversion unit cooling device further includes a one-way valve, the one-way valve is connected in parallel with the coolant pump, an inlet of the one-way valve is communicated with the first condenser, and an outlet is communicated with the throttling element.

Preferably, the air conditioning system further includes a second condenser, and the second condenser is connected between the heat exchanger and the evaporator.

The embodiment of the invention has the beneficial effects that: the photovoltaic air conditioning system provided by the embodiment of the invention may be adapted to various photovoltaic power plants with different capacities, and a photovoltaic power plant may be seamlessly and effectively combined with a heat ventilation air conditioner.

### Brief description of the drawings

Fig. 1 is a structure diagram of a photovoltaic air conditioning system; and
Fig. 2 is a diagram of a frequency conversion unit cooling structure of a photovoltaic air conditioning system.

### Detailed description of the embodiments

In order to make a purpose, technical solutions and advantages of the invention clearer, the invention will be further described below with reference to the drawings and embodiments in detail. It should be understood that specific embodiments described here are only adopted to explain the invention and not intended to limit the invention.

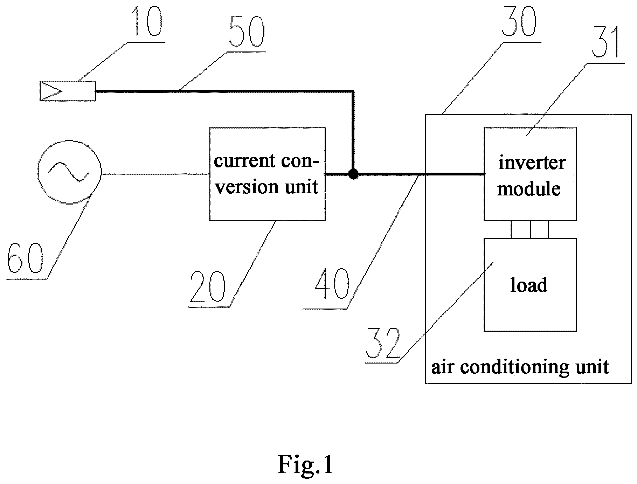

Fig. 1 is a structure diagram of a photovoltaic air conditioning system. The photovoltaic air conditioning system includes a photovoltaic cell array 10, a current conversion unit 20, an air conditioning unit 30, a first direct current bus-bar 40 and a second direct current bus-bar 50. The air conditioning unit 30 further includes a first inverter module 31, the first inverter module 31, as a part of an air conditioning frequency converter, belongs to a standard accessory of the air conditioning unit 30, the first inverter module 31 is configured to current direct current into alternating current for supply to a load 32, the load 32 at least includes a variable frequency compressor of the air conditioning unit, and capacity of the first inverter module 31 is configured according to a power requirement of the air conditioning unit 30. Preferably, the first inverter module 31 is arranged onboard, and is mounted on the air conditioning unit 30.

The photovoltaic cell array 10 is connected with the first direct current bus-bar 40 through the second direct current bus-bar 50, so that the direct current generated by the photovoltaic cell array 10 is directly supplied to the air conditioning unit 30 through the second direct current bus-bar 50 and the first direct current bus-bar 40.

The current conversion unit 20 is an independent structure, its one end is connected with a public grid 60, and the other end is connected with the first inverter module 31 through the first direct current bus-bar 40. The current conversion unit 20 includes a rectifier module and a second inverter module, the rectifier module 21 is configured to convert alternating current of the public grid 60 into direct current for supply to the air conditioning unit 30, and the second inverter module is configured for photovoltaic grid-connection power generation, and is configured to convert the direct current generated by the photovoltaic cell array 10 into alternating current for connection to the public grid 60. Capacity of the current conversion unit 20 is configured according to a requirement of the photovoltaic cell array 10 and/or the public grid 60. The current conversion unit 20, as an independent structure, may not be limited by the air conditioning unit, and may also be conveniently wired and mounted according to a construction requirement of a photovoltaic power plant. A first main function of the current conversion unit 20 is to implement Maximum Power Point Tracking (MPPT) of the photovoltaic cell array 10, and a second main function is to implement optimal configuration of energy, wherein photovoltaic energy is preferably used for power generation to ensure that output power of the photovoltaic cell array 10 is preferably used for the air conditioning unit 30, and if there is no sufficient energy, the public grid 60 supplements energy. Preferably, the current conversion unit 20 is a four-quadrant current converter.

When the output power of the photovoltaic cell array 10 is higher than or equal to input power required by running of the air conditioning unit 30, the direct current generated by the photovoltaic cell array 10 is inverted into alternating current for supply to the air conditioning unit through the first inverter module 31, the air conditioning unit 30 is powered by the photovoltaic cell array 10 only, and is not required to be powered by the public grid 60, and the current conversion unit 20 does not work.

When the output power of the photovoltaic cell array 10 is lower than the input power required by running of the air conditioning unit 30, the direct current generated by the photovoltaic cell array 10 is transmitted to the first inverter module 31 for supply to the air conditioning unit 30, commercial power is simultaneously rectified into direct current for transmission to the first inverter module 31 through the current conversion unit 20, and the air conditioning unit is jointly powered by the public grid 60 and the photovoltaic cell array 10 to compensate for a shortcoming of photovoltaic power generation.

When the output power of the photovoltaic cell array 10 is higher than the input power required by running of the air conditioning unit 30, or when the air conditioning unit 30 does not work, the current conversion unit 20 converts a part or all of the direct current output by the photovoltaic cell array into alternating current for transmission to the public grid 60 to implement grid-connected power generation. The current conversion unit 20 is independent of a controller of the air conditioning unit 30, so grid-connected power generation may be implemented only by the photovoltaic cell array 10 under the condition that the air conditioning unit 30 is not started.

Preferably, the photovoltaic air conditioning system of the embodiment further includes a collector unit and a power distribution unit, and the photovoltaic cell array 10, the photovoltaic collector unit, the power distribution unit and the second direct current bus-bar 50 are sequentially connected.

Preferably, the photovoltaic air conditioning system of the embodiment further includes a direct current step-up module, and the direct current step-up module is arranged between the power distribution unit and the second direct current bus-bar 50.

In the embodiment, the air conditioning unit 30 is a central air conditioning unit and preferably a centrifugal water-cooled unit, a screw type water-cooled unit or a multi-connected air conditioning unit.

According to the photovoltaic air conditioning system provided by the embodiment, the air conditioning unit may be normally powered, and in addition, a type of the current conversion unit 20 may be freely selected according to a practical requirement without any limit of a factory equipment parameter of the air conditioning unit, so that applicability of the air conditioning unit is improved, the air conditioning unit may be matched with any photovoltaic power plant, and waste of electric energy of the photovoltaic power plant may be avoided.

The photovoltaic air conditioning system further includes a current conversion unit cooling device adopting a cooling manner such as air cooling, water cooling and coolant cooling. When the air cooling manner is adopted, the current conversion unit 20 is cooled by a radiator and a radiation fan. When a water cooling manner is adopted, the current conversion unit 20 is cooled by a water pump and a water circulating pipeline.

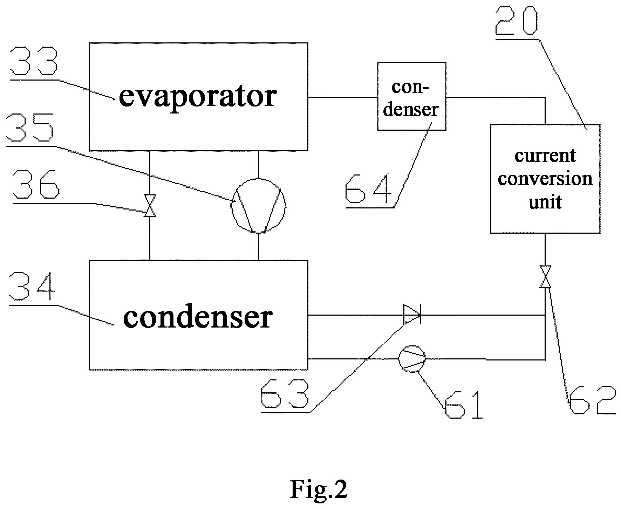

Preferably, the coolant cooling manner is adopted for cooling the current conversion unit. As shown in Fig. 2, the air conditioning unit 30 includes an evaporator 33, first condenser 34, compressor 35 and first throttling element 36 which are connected into a cooling circulation system.

The current conversion unit cooling device includes a coolant pump 61, second throttling element 62 and heat exchanger (not shown in the figure) which are sequentially connected in series. A first end of the coolant pump 61 is communicated with the first condenser 34, a second end is communicated with the second throttling element 62, a first end of the heat exchanger is communicated with the second throttling element 62, a second end is communicated with the evaporator 33, the heat exchanger contacts with the current conversion unit 20, and the current conversion unit 20 is cooled by heat exchange of the heat exchanger and the current conversion unit 20, that is, the heat exchanger functions as a cooler. The second throttling element 62 may be one or a combination of multiple of a capillary tube, a thermal expansion valve, an electronic expansion valve and a throttling orifice plate.

Wherein, the heat exchanger is a metal cooling plate into which a coolant flow passage is embedded, the metal plate contacts with the current conversion unit, a proper cooling type may also be selected according to a factor such as a field environment condition and a shape and cooling requirement of the current conversion unit, and for example, for a device incapable of contact heat exchange or with a low cooling requirement, a finned tube heat exchanger, a plate-fin heat exchanger or the like may be adopted as a cooler.

The current conversion cooling device further includes a one-way valve 63, the one-way valve 63 is arranged in parallel with the coolant pump 61, an inlet of the one-way valve 63 is communicated with the first condenser 34, and an outlet is communicated with the second throttling element 62. Due to arrangement of the one-way valve 63, backflow of a coolant and bypass short-circuit of the coolant may be prevented, and sufficient coolant for cooling a frequency converter may be ensured. By the coolant cooling manner, a remarkable cooling effect may be achieved, and a component type selection requirement may also be properly lowered.

The coolant may absorb a great amount of heat after flowing through the current conversion unit, and the heat may be finally accumulated into the coolant in the air conditioning unit to continuously increase system temperature and system pressure of the air conditioning unit in a shutdown state if not being released. If a cooling system works for a long time in the shutdown state of the air conditioning unit, the system temperature may be continuously increased to cause influence on the cooling effect of the current conversion unit, and the system pressure may be continuously increased to cause influence on safety of the whole cooling circulation system. Preferably, a second condenser 64 is arranged between the heat exchanger and the evaporator 33, the low-temperature coolant flowing out of the second throttling element 62 absorbs heat dissipated by the current conversion unit at the cooler to be evaporator into high-temperature coolant vapor, the coolant vapor exchanges heat with air or water to be condensed into a liquid coolant again when flowing to the second condenser 64, and the liquid coolant enters the evaporator 33, and returns to the air conditioning unit to implement a cooling cycle.

A function of the second condenser 64 is to improve reliability of the system and enable the cooling system to normally work for a long time in the shutdown state of the air conditioning unit. In addition, when the air conditioning unit is started to work, the second condenser 64 may also prevent a great amount of heat from entering the evaporator 33 to reduce energy efficiency of the air conditioning system. The second condenser 64 usually adopts a finned tube heat exchanger or a plate heat exchanger.

When the current conversion unit 20 consists of multiple independent modules, multiple parallel heat exchange branches may be correspondingly arranged between the coolant pump 61 and the evaporator 33, and a throttling element and one or more heat exchangers are arranged on each branch to cool each module.

The photovoltaic air conditioning system with the current conversion cooling device provided by the invention may implement cooling of an electronic power device under the conditions that the air conditioning unit is started and not started, so that the problem that the electronic power device may not be cooled if the air conditioning unit is not started in the conventional art is solved, cooling of the electronic power device in a photovoltaic power generation system is implemented under the condition that the air conditioning unit is not started, reliability of the photovoltaic system is improved, and in addition, service life of the air conditioning unit is prolonged.

From the above, the invention has the advantages that: adaptability to various photovoltaic power plants with different capacities may be achieved, and a photovoltaic power plant may be seamlessly and effectively combined with a heat ventilation air conditioner; and in addition, cooling of the electronic power device in the photovoltaic power generation system is implemented under the condition that the air conditioning unit is not started, reliability of the photovoltaic system is improved, and in addition, service life of the air conditioning unit is prolonged.

## Claims

1. A photovoltaic air conditioning system, comprising a photovoltaic cell array (10), an air conditioning unit (30), a current conversion unit (20), a first direct current bus-bar (40) and a second direct current bus-bar (50), wherein
the air conditioning unit (30) comprises a first inverter module (31) configured to supply power to the air conditioning unit (30);
the current conversion unit (20) is an independent structure, first end of the current conversion unit (20) is configured to be
connected with a public grid, and second end of the
current conversion unit (20) is electrically connected with the first inverter module (31) through the first direct current bus-bar (40); and
the photovoltaic cell array (10) is electrically connected with the first direct current bus-bar (40) through the second direct current bus-bar (50);
wherein the current conversion unit (20) comprises a rectifier module and a second inverter module, the rectifier module is configured to convert alternating current of the public grid (60) into direct current for supply to the air conditioning unit (30), and the second inverter module is configured to convert direct current generated by the photovoltaic cell array (10) into alternating current for connection to the public grid (60);
wherein capacity of the current conversion unit (20) is configured according to a requirement of the photovoltaic cell array (10) or the public grid (60); **characterized in that**:
the photovoltaic air conditioning system further comprises a current conversion unit (20) cooling device;
the air conditioning unit (30) further comprises an evaporator (33) and a first condenser (34),
the current conversion unit (20) cooling device comprises a coolant pump (61), throttling element (62) and heat exchanger which are sequentially connected in series,
a first end of the coolant pump (61) is communicated with the first condenser (34), a second end of the coolant pump (61) is communicated with the throttling element (62), a first end of the heat exchanger is communicated with the throttling element (62), a second end of the heat exchanger is communicated with the evaporator, and the current conversion unit (20) is configured to be cooled by heat exchange of the heat exchanger and the current conversion unit (20).

2. The photovoltaic air conditioning system according to claim 1, wherein
the photovoltaic cell array (10) is configured to, when output power of the photovoltaic cell array (10) is higher than or equal to input power required by running of the air conditioning unit (30), power the air conditioning unit (30); and
the photovoltaic cell array (10) is configured to, when the output power of the photovoltaic cell array (10) is lower than the input power required by running of the air conditioning unit (30), power the air conditioning unit (30) jointly by the public grid (60).

3. The photovoltaic air conditioning system according to claim 1, wherein
when the output power of the photovoltaic cell array (10) is higher than the input power required by running of the air conditioning unit (30), or when the air conditioning unit (30) does not work, the current conversion unit (20) is configured to convert direct current output by the photovoltaic cell array (10) into alternating current for transmission to the public grid (60).

4. The photovoltaic air conditioning system according to claim 3, wherein
the current conversion unit (20) is a four-quadrant current converter.

5. The photovoltaic air conditioning system according to claim 1,
further comprising a photovoltaic collector unit and power distribution unit which are arranged between the photovoltaic cell array (10) and the second direct current bus-bar (50), wherein the photovoltaic cell array (10), the photovoltaic collector unit, the power allocation unit and the second direct current bus-bar (50) are sequentially connected.

6. The photovoltaic air conditioning system according to claim 1, wherein
the air conditioning unit (30) is a centrifugal water-cooled air conditioning unit, a screw type water-cooled air conditioning unit or a multi-connected air conditioning unit .

7. The photovoltaic air conditioning system according to claim 1, wherein
the current conversion unit (20) cooling device further comprises a one-way valve (63), the one-way valve (63) is connected in parallel with the coolant pump (61), an inlet of the one-way valve (63) is communicated with the first condenser (34), and an outlet is communicated with the throttling element (62).

8. The photovoltaic air conditioning system according to claim 1,
further comprising a second condenser (64), wherein the second condenser (64) is connected between the heat exchanger and the evaporator (33).

9. The photovoltaic air conditioning system according to claim 1, wherein
the first inverter module (31) is arranged in a frequency converter of the air conditioning unit (30), capacity of the first inverter module (31) is configured according to power of the air conditioning unit (30).

10. The photovoltaic air conditioning system according to claim 1, wherein
the first inverter module (31) serves as a standard accessory of the air conditioning unit (30), the capacity of the first inverter module (31) is configured according to the power of the air conditioning unit (30), and
the capacity of the current conversion unit (20) is configured according to the requirement of the photovoltaic cell array (10) or the public grid (60).

## Patentansprüche

1. Photovoltaisches Klimatisierungssystem, das ein photovoltaisches Zellenarray (10), eine Klimatisierungseinheit (30), eine Stromwandlereinheit (20), eine erste Gleichstrombusschiene (40) und eine zweite Gleichstrombusschiene (50) umfasst, wobei
die Klimatisierungseinheit (30) ein erstes Invertermodul (31) umfasst, das dazu ausgelegt ist, die Klimatisierungseinheit (30) mit Leistung zu versorgen;
die Stromwandlereinheit (20) eine unabhängige Struktur ist, ein erstes Ende der Stromwandlereinheit (20) dazu ausgelegt ist, mit einem öffentlichen Netz verbunden zu werden, und ein zweites Ende der Stromwandlereinheit (20) über die erste Gleichstrombusschiene (40) mit dem ersten Invertermodul (31) elektrisch verbunden ist; und
das photovoltaische Zellenarray (10) über die zweite Gleichstrombusschiene (50) mit der ersten Gleichstrombusschiene (40) elektrisch verbunden ist;
wobei die Stromwandlereinheit (20) ein Gleichrichtermodul und ein zweites Invertermodul umfasst, wobei das Gleichrichtermodul dazu ausgelegt ist, Wechselstrom des öffentlichen Netzes (60) zur Versorgung der Klimatisierungseinheit (30) in Gleichstrom umzuwandeln, und das zweite Invertermodul dazu ausgelegt ist, Gleichstrom, der vom photovoltaischen Zellenarray (10) erzeugt wird, zur Verbindung zum öffentlichen Netz (60) in Wechselstrom umzuwandeln;
wobei eine Kapazität der Stromwandlereinheit (20) gemäß einer Anforderung des photovoltaischen Zellenarrays (10) oder des öffentlichen Netzes (60) ausgelegt ist; **dadurch gekennzeichnet, dass**:
das photovoltaische Klimatisierungssystem ferner eine Kühlvorrichtung der Stromwandlereinheit (20) umfasst;
die Klimatisierungseinheit (30) ferner einen Verdampfer (33) und einen ersten Verflüssiger (34) umfasst,
wobei die Kühlvorrichtung der Stromwandlereinheit (20) eine Kühlmittelpumpe (61), ein Drosselelement (62) und einen Wärmetauscher umfasst, die sequenziell in Reihe verbunden sind,
ein erstes Ende der Kühlmittelpumpe (61) an den ersten Verflüssiger (34) gekoppelt ist, ein zweites Ende der Kühlmittelpumpe (61) an das Drosselelement (62) gekoppelt ist, ein erstes Ende des Wärmetauschers an das Drosselelement (62) gekoppelt ist, ein zweites Ende des Wärmetauschers an den Verdampfer gekoppelt ist und die Stromwandlereinheit (20) dazu ausgelegt ist, durch einen Wärmeaustausch des Wärmetauschers und der Stromwandlereinheit (20) gekühlt zu werden.

2. Photovoltaisches Klimatisierungssystem nach Anspruch 1, wobei
das photovoltaische Zellenarray (10) dazu ausgelegt ist, wenn eine Ausgangsleistung des photovoltaischen Zellenarrays (10) höher als oder einer Eingangsleistung gleich ist, die zum Laufen der Klimatisierungseinheit (30) erforderlich ist, die Klimatisierungseinheit (30) mit Leistung zu versorgen; und
das photovoltaische Zellenarray (10) dazu ausgelegt ist, wenn die Ausgangsleistung des photovoltaischen Zellenarrays (10) niedriger als die Eingangsleistung ist, die zum Laufen der Klimatisierungseinheit (30) erforderlich ist, die Klimatisierungseinheit (30) zusammen mit dem öffentlichen Netz (60) mit Leistung zu versorgen.

3. Photovoltaisches Klimatisierungssystem nach Anspruch 1, wobei,
wenn die Ausgangsleistung des photovoltaischen Zellenarrays (10) höher als die Eingangsleistung ist, die zum Laufen der Klimatisierungseinheit (30) erforderlich ist, oder wenn die Klimatisierungseinheit (30) nicht arbeitet, die Stromwandlereinheit (20) dazu ausgelegt ist, Gleichstrom, der vom photovoltaischen Zellenarray (10) ausgegeben wird, zur Übertragung zum öffentlichen Netz (60) in Wechselstrom umzuwandeln.

4. Photovoltaisches Klimatisierungssystem nach Anspruch 3, wobei
die Stromwandlereinheit (20) ein Vierquadrantenstromwandler ist.

5. Photovoltaisches Klimatisierungssystem nach Anspruch 1,
das ferner eine photovoltaische Sammlereinheit und eine Stromverteilungseinheit umfasst, die zwischen dem photovoltaischen Zellenarray (10) und der zweiten Gleichstrombusschiene (50) angeordnet sind, wobei das photovoltaische Zellenarray (10), die photovoltaische Sammlereinheit, die Stromzuteilungseinheit und die zweite Gleichstrombusschiene (50) sequenziell verbunden sind.

6. Photovoltaisches Klimatisierungssystem nach Anspruch 1, wobei
die Klimatisierungseinheit (30) eine wassergekühlte Zentrifugenklimatisierungseinheit, eine wassergekühlte Schraubenklimatisierungseinheit oder eine mehrfach verbundene Klimatisierungseinheit ist.

7. Photovoltaisches Klimatisierungssystem nach Anspruch 1, wobei
die Kühlvorrichtung der Stromwandlereinheit (20) ferner ein Einwegeventil (63) umfasst, wobei das Einwegeventil (63) parallel zur Kühlmittelpumpe (61) verbunden ist, ein Einlass des Einwegeventils (63) an den ersten Verflüssiger (34) gekoppelt ist und ein Auslass an das Drosselelement (62) gekoppelt ist.

8. Photovoltaisches Klimatisierungssystem nach Anspruch 1,
das ferner einen zweiten Verflüssiger (64) umfasst, wobei der zweite Verflüssiger (64) zwischen dem Wärmetauscher und dem Verdampfer (33) verbunden ist.

9. Photovoltaisches Klimatisierungssystem nach Anspruch 1, wobei
das erste Invertermodul (31) in einem Frequenzwandler der Klimatisierungseinheit (30) angeordnet ist, eine Kapazität des ersten Invertermoduls (31) gemäß einer Leistung der Klimatisierungseinheit (30) ausgelegt ist.

10. Photovoltaisches Klimatisierungssystem nach Anspruch 1, wobei
das erste Invertermodul (31) als ein Standardzubehör der Klimatisierungseinheit (30) fungiert, die Kapazität des ersten Invertermoduls (31) gemäß der Leistung der Klimatisierungseinheit (30) ausgelegt ist und
die Kapazität der Stromwandlereinheit (20) gemäß der Anforderung des photovoltaischen Zellenarrays (10) oder des öffentlichen Netzes (60) ausgelegt ist.

## Revendications

1. Système photovoltaïque de conditionnement d'air, comprenant un réseau de cellules photovoltaïques (10), une unité de conditionnement d'air (30), une unité de conversion de courant (20), une première barre omnibus à courant continu (40) et une seconde barre omnibus à courant continu (50), dans lequel
l'unité de conditionnement d'air (30) comprend un premier module onduleur (31) configuré pour fournir de l'énergie à l'unité de conditionnement d'air (30) ;
l'unité de conversion de courant (20) est une structure indépendante, une première extrémité de l'unité de conversion de courant (20) est configurée pour être raccordée à un réseau électrique public, et une seconde extrémité de l'unité de conversion de courant (20) est raccordée électriquement au premier module onduleur (31) au moyen de la première barre omnibus à courant continu (40) ; et
le réseau de cellules photovoltaïques (10) est raccordé électriquement à la première barre omnibus à courant continu (40) au moyen de la seconde barre omnibus à courant continu (50) ;
dans lequel l'unité de conversion de courant (20) comprend un module redresseur et un second module onduleur, le module redresseur est configuré pour convertir le courant alternatif du réseau électrique public (60) en courant continu pour alimenter l'unité de conditionnement d'air (30), et le second module onduleur est configuré pour convertir le courant continu généré par le réseau de cellules photovoltaïques (10) en courant alternatif pour une connexion au réseau électrique public (60) ;
dans lequel une capacité de l'unité de conversion de courant (20) est configurée en fonction d'une exigence du réseau de cellules photovoltaïques (10) ou du réseau électrique public (60) ; **caractérisé en ce que** :
le système photovoltaïque de conditionnement d'air comprend en outre un dispositif de refroidissement d'unité de conversion de courant (20) ;
l'unité de conditionnement d'air (30) comprend en outre un évaporateur (33) et un premier condensateur (34),
le dispositif de refroidissement d'unité de conversion de courant (20) comprend une pompe de liquide de refroidissement (61), un élément d'étranglement (62) et un échangeur de chaleur qui sont de manière séquentielle raccordés en série,
une première extrémité de la pompe de liquide de refroidissement (61) est en communication avec le premier condensateur (34), une seconde extrémité de la pompe de liquide de refroidissement (61) est en communication avec l'élément d'étranglement (62), une première extrémité de l'échangeur de chaleur est en communication avec l'élément d'étranglement (62), une seconde extrémité de l'échangeur de chaleur est en communication avec l'évaporateur, et l'unité de conversion de courant (20) est configurée pour être refroidie au moyen d'un échange de chaleur de l'échangeur de chaleur et de l'unité de conversion de courant (20).

2. Système photovoltaïque de conditionnement d'air selon la revendication 1, dans lequel
le réseau de cellules photovoltaïques (10) est configuré, lorsqu'une puissance de sortie du réseau de cellules photovoltaïques (10) est supérieure ou égale à une puissance d'entrée requise par le fonctionnement de l'unité de conditionnement d'air (30), pour alimenter l'unité de conditionnement d'air (30) ; et
le réseau de cellules photovoltaïques (10) est configuré, lorsque la puissance de sortie du réseau de cellules photovoltaïques (10) est inférieure à la puissance d'entrée requise par le fonctionnement de l'unité de conditionnement d'air (30), pour alimenter l'unité de conditionnement d'air (30) conjointement au moyen du réseau électrique public (60).

3. Système photovoltaïque de conditionnement d'air selon la revendication 1, dans lequel
lorsque la puissance de sortie du réseau de cellules photovoltaïques (10) est supérieure à la puissance d'entrée requise par le fonctionnement de l'unité de conditionnement d'air (30), ou lorsque l'unité de conditionnement d'air (30) ne fonctionne pas, l'unité de conversion de courant (20) est configurée pour convertir le courant continu produit par le réseau de cellules photovoltaïques (10) en courant alternatif pour une transmission au réseau électrique public (60).

4. Système photovoltaïque de conditionnement d'air selon la revendication 3, dans lequel
l'unité de conversion de courant (20) est un convertisseur de courant à quatre quadrants.

5. Système photovoltaïque de conditionnement d'air selon la revendication 1,
comprenant en outre une unité de collecteur photovoltaïque et une unité de distribution d'énergie qui sont disposées entre le réseau de cellules photovoltaïques (10) et la seconde barre omnibus à courant continu (50), dans lequel le réseau de cellules photovoltaïques (10), l'unité de collecteur photovoltaïque, l'unité d'attribution d'énergie et la seconde barre omnibus à courant continu (50) sont raccordés de manière séquentielle.

6. Système photovoltaïque de conditionnement d'air selon la revendication 1, dans lequel
l'unité de conditionnement d'air (30) est une unité centrifuge de conditionnement d'air refroidie par l'eau, une unité de conditionnement d'air refroidie par l'eau de type à vis ou une unité de conditionnement d'air multiconnectée.

7. Système photovoltaïque de conditionnement d'air selon la revendication 1, dans lequel
le dispositif de refroidissement d'unité de conversion de courant (20) comprend en outre une vanne unidirectionnelle (63), la vanne unidirectionnelle (63) est raccordée en parallèle à la pompe de liquide de refroidissement (61), une entrée de la vanne unidirectionnelle (63) est en communication avec le premier condensateur (34), et une sortie est en communication avec l'élément d'étranglement (62).

8. Système photovoltaïque de conditionnement d'air selon la revendication 1,
comprenant en outre un second condensateur (64), dans lequel le second condensateur (64) est raccordé entre l'échangeur de chaleur et l'évaporateur (33).

9. Système photovoltaïque de conditionnement d'air selon la revendication 1, dans lequel
le premier module onduleur (31) est disposé dans un convertisseur de fréquence de l'unité de conditionnement d'air (30), une capacité du premier module onduleur (31) est configurée en fonction de la puissance de l'unité de conditionnement d'air (30).

10. Système photovoltaïque de conditionnement d'air selon la revendication 1, dans lequel
le premier module onduleur (31) fait office d'accessoire standard de l'unité de conditionnement d'air (30), la capacité du premier module onduleur (31) est configurée en fonction de la puissance de l'unité de conditionnement d'air (30) et
la capacité de l'unité de conversion de courant (20) est configurée en fonction de l'exigence du réseau de cellules photovoltaïques (10) ou du réseau électrique public (60).
